# EUROPÄISCHE PATENTSCHRIFT

(11) **EP 1 312 118 B1**
(45) Veröffentlichungstag und Bekanntmachung des Hinweises auf die Patenterteilung: **16.10.2013**
(21) Anmeldenummer: 01956418.6
(22) Anmeldetag: 01.08.2001
(51) Int. Cl.: H01L 27/01, H01L 21/822

(54) **VERFAHREN ZUR HERSTELLUNG PASSIVER BAUELEMENTE AUF EINEM HALBLEITERSUBSTRAT**
METHODS FOR PRODUCING PASSIVE COMPONENTS ON A SEMICONDUCTOR SUBSTRATE
PROCEDES DE PRODUCTION DE COMPOSANTS PASSIFS SUR UN SUBSTRAT SEMI-CONDUCTEUR

(30) Priorität: 14.08.2000 DE 10039710
(43) Veröffentlichungstag der Anmeldung: 21.05.2003
(73) Patentinhaber: United Monolithic Semiconductors GmbH, 89081 Ulm (DE)
(72) Erfinder: BEHAMMER, Dag, 89079 Ulm (DE)
(74) Vertreter: Baur & Weber Patentanwälte
(86) Internationale Anmeldenummer: PCT/DE2001/002925
(87) Internationale Veröffentlichungsnummer: WO 2002/015273

(56) Entgegenhaltungen:
- WO-A-96/27210
- DE-A- 2 044 255
- DE-C- 19 531 629
- US-A- 3 778 689

## Beschreibung

Die Erfindung betrifft ein Verfahren zur Herstellung passiver Bauelemente, insbesondere Dünnschicht-Widerstandselemente und/oder Kapazitätselemente auf einem Halbleitersubstrat.

Bei der Herstellung von monolithisch integrierten Halbleiterschaltungen können vorteilhafterweise zusätzlich zu aktiven Halbleiterbauelementen (HBT, FET, ...) auf demselben Substrat auch passive Bauelemente, insbesondere Widerstände und/oder Kapazitäten erzeugt und untereinander und mit den aktiven Bauelementen zur Bildung komplexer Schaltungen verbunden werden. Die Widerstände werden typisch als Dünnschichtwiderstände, die Kapazitäten als MIM (Metall-Isolator-Metall) Schichtkapazitäten hergestellt.

Während in auf Silizium basierenden Technologien die für die aktiven Bauelemente eingesetzten Schichten oder Gebiete zugleich auch zur Erzeugung der passiven Bauelemente herangezogen werden können, ist bei Verbindungshalbleitern typischerweise für die Ausbildung der passiven Bauelemente die Abscheidung weiterer Schichten auf der zuvor üblicherweise passivierten Substratoberfläche erforderlich. Hierbei können zwar Bauelemente mit hoher Genauigkeit, guter Reproduzierbarkeit und über weite Bereiche einstellbaren Eigenschaften hergestellt werden, nachteilig sind aber die im Regelfall hohe Komplexität der Herstellungsprozesse und die damit verbundenen Kosten. Die häufig eingesetzten lift-oft-Prozesse führen zu unbefriedigenden Ausbeuten.

In der US 3 996 551 ist die Herstellung von hochohmigen und niederohmigen Widerstän-den auf einem isolierenden Substrat beschrieben, wobei mittels einer ersten Maske in einem lift-oft-Prozess eine strukturierte Doppelschicht aus hochohmigen Widerstandsmaterial auf dem Substrat und einem niederohmigen Widerstandsmaterial in der darüberliegenden Schicht abgeschieden wird. Durch teilweises Entfernen der niederohmigen Schicht mittels einer weiteren Maske werden hochohmige Widerstandsbereiche geschaffen, welche von einer Passivierungsschicht bedeckt werden. Über weitere Masken werden in der Passivierungsschicht Kontaktköcher zu der niederohmigen Schicht und metallische Kontakte erzeugt.

Die US 4 878 770 beschreibt die selbstausrichtende Herstellung präziser Dünnschichtwiderstände in einer auf einem Substrat abgeschiedenen hochohmigen Widerstandsschicht, über welcher eine Kontaktschicht und soweit erforderlich eine Barrierenschicht als Diffusionsbarriere zwischen Kontaktschicht und Widerstandsschicht ganzflächig aufgebracht sind. Die gesamte Schichtenfolge wird unter Verwendung einer ersten Maske einheitlich zur Definition von Widerstandsgeometrien bis zum Substrat geätzt. In einem weiteren Schritt werden mittels einer zweiten. Maske in den mehrschichtigen Widerstandsgeometrien mittlere Bereiche zwischen Kontaktbereichen selektiv bis zur Widerstandsschicht geätzt.

Aus der DE 20 44 255 ist es unter anderem bekannt, auf ein nichtleitendes Substrat, z. B. Glas oder Keramik, ganzflächig nacheinander eine hochohmige Cermet-Schicht, eine niederohmige Chrom-Nickel-Schicht und eine Gold-Kontaktschicht abzuscheiden und durch strukturiertes und selektives Ätzen ein Dünnschicht-Widerstandsnetzwerk herzustellen. Ferner sind dort Verfahren zur Herstellung von Netzwerken mit Widerständen .und Kondensatoren beschrieben, welche hochohmige und niederohmige Tantalschichten verwenden.

Aus der WO 96/27210 ist u.a. ein Verfahren zur Herstellung von Widerständen und Kapazitäten bekannt, bei welchem auf ein Substrat eine Doppelschicht aus einer Widerstandsschicht und einer Kontaktschicht abgeschieden wird. In der Doppelschicht werden Bauelementbereiche für Widerstände und Kapazitäten separiert, innerhalb derer in einem folgenden Schritt durch Entfernen der Kontaktschicht Widerstände gebildet werden. Diese erste Bauelementebene wird mit einer Isolatorschicht abgedeckt, in welcher Kontaktlöcher freigelegt werden.

Eine darauf abgeschiedene Leiterschicht wird zur Bildung von Anschlußkontakten zu der Kontaktschicht und von deren Kapazitätsflächen strukturiert wird.

Die US 3 778 689 beschreibt die Herstellung eines Schaltkreises mit Dünnfilm-Kapazitäten und Widerständen. Für die Erzeugung der Kapazitäten werden in einer auf einem isolierenden Substrat abgeschiedenen Metallschicht untere Elektroden erzeugt. über der Metallschicht wird ganzflächig eine Isolatorschicht und über dieser eine Widerstandsschicht abgeschieden. Auf die Widerstandsschicht werden metallische Bereiche als Anschlüsse für Dünnfilmwiderstände und als obere Elektroden der Kapazitäten erzeugt. Die DE 195 31 629 C1 beschreibt ein Verfahren zur Herstellung einer EEPROM-Halbleiterstruktkur, bei welcher auf einem Substrat eine dicke Oxidschicht erzeugt wird, auf welcher Kondensatoren und Widerstände erzeugt werden.

Der Erfindung liegt die Aufgabe zugrunde, ein Verfahren zur Herstellung von passiven Bauelementen auf einem Halbleitersubstrat anzugeben, mit welchem bei geringem Aufwand verschiedene passive Bauelemente herstellbar sind.

Erfindungsgemäße Lösungen sind in den unabhängigen Ansprüchen beschrieben. Die abhängigen Ansprüche enthalten vorteilhafte Ausgestaltungen und Weiterbildungen der Erfindung.

Durch die Verwendung einer gemeinsamen Maske zur Erzeugung von Strukturen für Kapazitäten und Widerstände in der ersten Isolatorschicht ergibt sich eine aufwandsarme und damit kostengünstige Vorgehensweise. Die erste Isolatorschicht liegt dabei bei den Kapazitätsstrukturen über der Kontaktschicht als untere Metallisierungsebene für MIM-Kapazitäten und bei den Widerstandsstrukturen über einer Widerstandsschicht. Die Entfernung der ersten Isolatorschicht erfolgt dann selektiv sowohl zu der Kontaktschicht als auch zu der Widerstandsschicht.

Die Erfindung ermöglichst dabei gemäß einer Weiterbildung auf besonders einfache und vorteilhafte Weise die Erzeugung sowohl verschiedener Gruppen von Kapazitäts-Elementen, welche sich durch den Kapazitätsbelag, d.h. die flächenbezogene Kapazität unterscheiden, als auch verschiedener Gruppen von Widerstands-Elementen.

Durch selektives Entfernen der zweiten, oberen niederohmigen Widerstandsschicht in der in der ersten Isolatorschicht erzeugten Struktur bis zur ersten, unteren hochohmigen Widerstandsschicht kann ein hochohmiges Widerstandselement erzeugt werden, wobei durch Kombination der Maske für die Separation der Bauelemente und der Maske für die Erzeugung der Struktur in der ersten Isolatorschicht selbstausrichtend Widerstandselemente mit hoher geometrischer Präzision ähnlich der aus der US 4 878 770 bekannten Vorgehensweise entstehen können. Eine danach abgeschiedene zweite Isolatorschicht kann vorteilhafterweise aus einem Material bestehen, welches korrosionsschützend für die Widerstandsschicht wirkt.

In den für erste Kapazitäts-Elemente über unteren Kapazitäts-Elektroden der Kontaktschicht erzeugten Strukturen in der ersten Isolatorschicht kann eine zweite Isolatorschicht abgeschieden werden, deren Eigenschaften nach Material und Schichtdicke auf hohen Kapazitätsbelag ausgelegt sein können. Insbesondere kann das Material der zweiten Isolatorschicht eine relativ hohe Dielektrizitätskonstante aufweisen. Durch die bevorzugte ganzflächige Abscheidung der zweiten Isolatorschicht entsteht außerhalb der in der ersten Isolatorschicht freigelegten Strukturen eine Isolator-Doppelschicht. Durch auf der zweiten Isolatorschicht abgeschiedene Metallflächen als obere Kapazitäts-Elektroden von MIM-Kapazitäten können dann erste Kapazitäts-Elemente hohen Kapazitätsbelags mit nur der zweiten Isolatorschicht als Dielektrikum oder zweite Kapazitäts-Elemente niedrigeren Kapazitätsbelags mit der Isolator-Doppelschicht als Dielektrikum mittels einer gemeinsamen Maske hergestellt werden.

Die derartige Herstellung von Kapazitäten unterschiedlichen Kapazitätsbelags ist auch unabhängig von der gleichzeitigen Erzeugung von KapazitätsStrukturen und Widerstands-Strukturen mittels einer gemeinsamen Maske von besonderem Vorteil.

Bei der Herstellung von Dünnschicht-Widerstands-Elementen durch aufeinanderfolgendes Abscheiden einer ersten Widerstandsschicht, einer zweiten Widerstandsschicht und einer Kontaktschicht wird vorteilhafterweise für wenigstens eine der Widerstandsschichten als ein Material gewählt, welches einerseits als Diffusions-Barriere zwischen der Kontaktschicht und einem unter der Barrierenschicht liegenden Material und andererseits zugleich als Widerstandsmaterial dient, und es wird mindestens ein Widerstands-Element auch in der Barrierenschicht, vorzugsweise mindestens je ein Widerstands-Element in jeder der beiden Widerstandsschichten erzeugt. Vorzugsweise wird die zweite Widerstandsschicht als niederohmige Barrierenschicht ausgebildet. Die Barrierenschicht ist insbesondere dadurch von Vorteil, dass die Schichtenfolge von erster Widerstandsschicht, zweiter Widerstandsschicht und Kontaktschicht auch auf in der Passivierungsschicht geöffneten Kontaktfenstern über aktiven Bauelementen abgeschieden werden können, ohne dass durch Diffusion zwischen über den Kontaktfenstern abgeschiedener Kontaktschicht und einem aktiven Halbleiterbereich Beeinträchtigungen des aktiven Halbleiterbauelements auftreten. Der Stromfluss zum aktiven Halbleiterbereich erfolgt niederohmig senkrecht zu den Widerstandsschichten.

Das erfindungsgemäße Herstellungsverfahren kann vollständig oder weitestgehend auf lift-off-Prozesse verzichten und kann zur Ausbildung von Strukturen in einer Schicht vorteilhafterweise weitgehend trocken- oder naßschemische Ätzverfahren einsetzen, wobei insbesondere Ätzmittel eingesetzt werden können, welche selektiv auf einzelne Schichtmaterialien wirken und den Ätzprozess an der darunterliegenden Schicht automatisch stoppen.

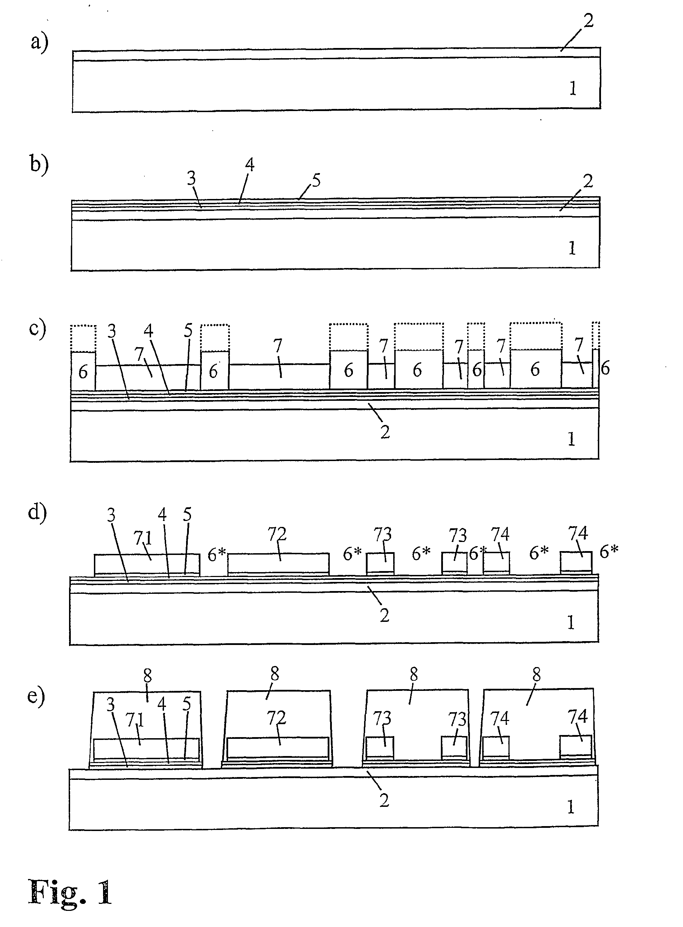

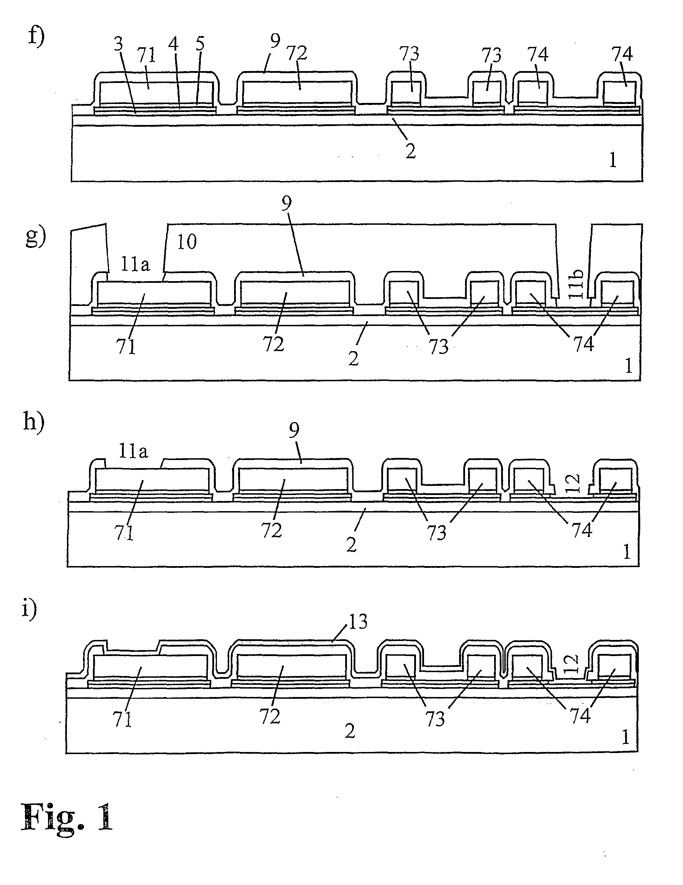

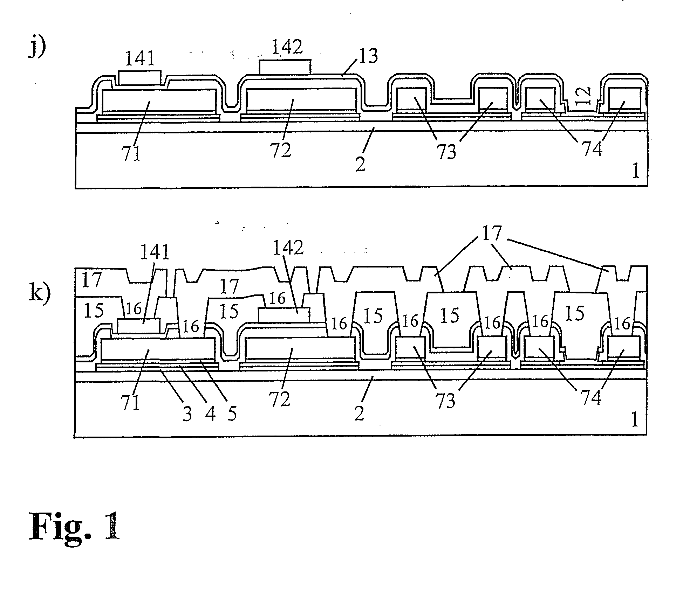

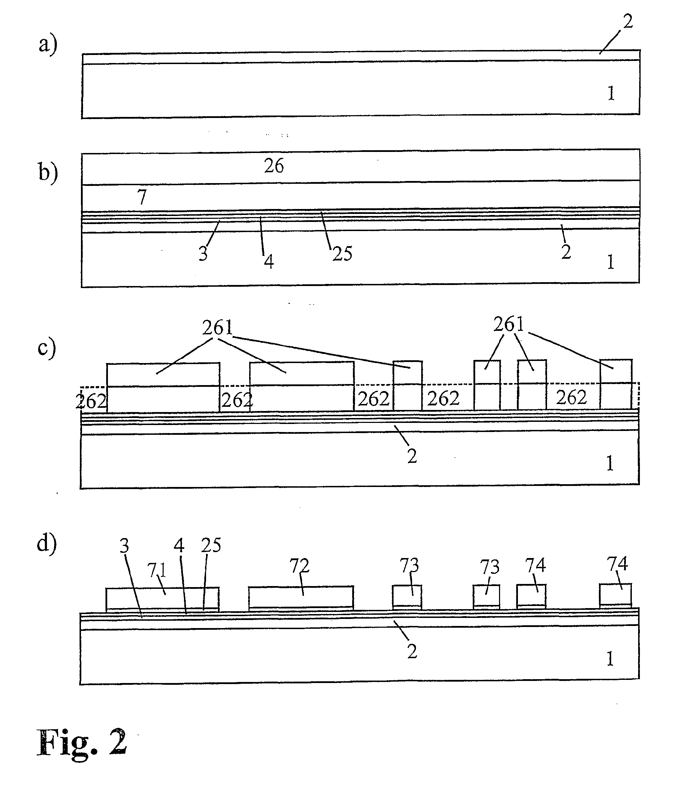

Die Erfindung ist nachfolgend anhand eines Beispiels der Herstellung einer komplexen Bandelementanordnung mit hochohmigen und niederohmigen Widerstands-Elementen sowie MIM-Kapazitäts-Elementen verschiedener Kapa zitätsbeläge unter Bezugnahme auf die Abbildungen noch eingehend veranschaulicht. Die aufeinanderfolgenden Situationen einer ersten vorteilhaften Ausführungsform eines Herstellungsprozesses sind in Fig.1 mit Abbildungen a bis k bezeichnet. Anhand von Fig.2, Abb. a bis d sind vorteilhafte Varianten der einleitenden Schritte des Herstellungsprozesses beschrieben.

Nach der Integration der nicht mit abgebildeten aktiven Bauelemente im Substrat 1 wird die Oberfläche des Substrats und der aktiven Bauelemente durch ein Dielektrikum 2 passiviert (Fig.1, a). Auf den aktiven Bauelementen werden Kontaktfenster in der Passivierungsschicht geöffnet und unter Umständen eine dünne Schicht eines Metalls aufgebracht.

Auf das passivierte Substrat (einschließlich aktiver Bauelemente) werden nacheinander ganzflächig eine erste Widerstandsschicht 3 aus hochohmigem Widerstandsmaterial, vorzugsweise WSiₓN_{y}, eine zweite Widerstandsschicht 4 aus demgegenüber niederohmigerem Widerstandsmaterial und eine Metallschicht 5 abgeschieden (Fig.1, b). Die zweite Widerstandschicht kann insbesondere aus (WTi)N_{z} bestehen und bildet zugleich eine Diffusionsbarriere zwischen der Metallschicht 5 und der ersten Widerstandsschicht 3 bzw. dem aktiven Halbleitermaterial oder einer darauf befindlichen Schicht anderen Metalls in einem Kontaktfenster. In den Widerstandsschichten 3 und 4 kann vorteilhafterweise jeweils bei den beispielhaft angegebenen Materialien über den Stickstoffgehalt der Schichtwiderstand und/oder der Temperaturkoeffizient des Widerstandsmaterials beeinflusst werden. Die Metallschicht 5 kann beispielsweise aus Gold bestehen. Die Schichten 3, 4 und 5 können vorteilhafterweise in einem Prozessgang aufgebracht, insbesondere aufgesputtert werden.

Auf die Metallschicht 5 wird eine erste Photolackschicht 6 aufgetragen, in welcher Elektrodenbereiche freigelegt werden. In den freigelegten Elektrodenbereichen wird die Metallschicht durch eine dickere Kontaktmetallisierung 7 verstärkt, beispielsweise durch galvanische Abscheidung oder durch Aufdampfen eines Metalls, welches vorzugsweise eine gleiche oder ähnliche Zusammensetzung besitzt wie die Metallschicht 5 (Abb. c). Beim Aufdampfen auf der Fotolackschicht 6 abgelagertes Kontaktmetall wird mit Ablösen des restlichen Photolacks im lift-off-Verfahren entfernt. Die leitende Doppelschicht sei als Kontaktschicht bezeichnet und bildet eine erste Elektrodenebene. Die Metallschicht 5 kann in einer günstigen Ausführung auch aus einer Schichtfolge Titan auf Gold bestehen. Dabei verbessert die Titanschicht die Haftungseigenschaften des nachfolgend aufgebrachten Fotolackes 6. Die Titanschicht wird nach der Strukturierung des Fotolackes naßchemisch strukturiert, bevor die Kontaktmetallisierung 7 aufgebracht wird.

Im Fall der Aufdampfung der Schicht 7 kann auf die Schicht 5 verzichtet werden. Ein Sputterätzprozeß unmittelbar vor der Aufdampfung der Schicht 7 auf die Schicht 4 kann den Kontaktwiderstand zwischen den Schichten 7 und 4 minimieren.

Nach Entfernen der Fotolackmaske 6 wird die dünne Metallschicht 5 in den Lücken 6* zwischen den Elektroden 7 der Kontaktmetallisierung nasschemisch selektiv zur Schicht 4 entfernt (Abb. d) und es entstehen Elektroden auf der zweiten Widerstandsschicht, welche beispielsweise als untere Elektroden 71, 72 für MIM-Kapazitäts-Elemente oder als Anschlußelektroden 73, 74 für Dünnschicht-Widerstände vorgesehen sein können.

In einer weiteren Fotolackmaske 8 werden die Umrisse von verschiedenen Bauelementen sowie evtl. von Verbindungsleitungen in der Elektrodenebene der Schicht 7 strukturiert und durch selektives Ätzen der Widerstandsschichten 3 und 4 bis zur Passivierungsschicht 2 werden die verschiedenen Bauelemente separiert (Abb. e).

Nach Ablösen der zweiten Fotolackmaske 8 wird eine erste Isolatorschicht 9 ganzflächig aufgebracht (Abb. f) und mit einer weiteren Fotolackschicht 10 bedeckt. Mittels der Fotolackschicht 10 werden in der ersten Isolatorschicht eine Öffnung 11a über der Kapazitätselektrode 71 und eine weitere Öffnung 11 b über der zweiten Widerstandsschicht 4 zwischen den Anschlusselektroden 74 freigeätzt (Abb. g). Der Ätzvorgang stoppt an der Elektrodenschicht 7 bzw. der zweiten Widerstandsschicht 4 automatisch. Die in der ersten Isolatorschicht 9 freigelegten Öffnung 11 b dient als Maske zum selektiven Ätzen einer Öffnung 12 in der zweiten Widerstandsschicht 4 gegen die erste Widerstandsschicht 3. Zwischen den Anschlusselektroden 74 entsteht dadurch ein hochohmiges Dünnschicht-Widerstands-Element, dessen Eigenschaften maßgeblich durch die erste Widerstandsschicht 3 bestimmt sind, wogegen zwischen den Anschlusselektroden 73 ein niederohmiges Widerstands-Element ausgebildet ist, dessen Eigenschaften primär durch das Material der zweiten Widerstandsschicht 4 gegeben sind (Abb. h).

Auf die in Abb. h. skizzierte Anordnung wird ganzflächig eine zweite Isolatorschicht 13 abgeschieden (Abb. i), welche in der Öffnung 11a über der Elektrode 71 als Dielektrikum für erste MIM-Kapazitäten mit hohem Kapazitätsbelag und vorteilhafterweise in der Öffnung 12 als Korrosionsschutz für die dort freiliegende erste Widerstandsschicht 3 dient. Gleichzeitig entsteht durch die zweite Isolatorschicht über der Elektrode 72 eine dickere Isolator-Doppelschicht 9+13, welche als Dielektrikum für zweite MIM-Kapazitäts-Elemente mit geringerem Kapazitätsbelag als bei den ersten MIM-Kapazität-Elementen dient.

Die auf der zweiten Isolatorschicht in einem gemeinsamen Prozessschritt erzeugten oberen Elektroden 141 und 142 (Abb. j) bilden mit den unteren Elektroden 71 bzw. 72 die genannten Kapazitäts-Elemente mit höherem Kapazitätsbelag (71/141) bzw. niedrigerem Kapazitätsbelag (72/142), wobei die Werte der Kapazitätsbeläge durch die Schichtdicken und Materialeigenschaften der Isolatorschichten 9 und 13 einstellbar sind. Die Isolatorschichten 9, 13 können aus gleichen oder verschiedenen Materialien aufgebaut sein. Insbesondere kann für die erste Isolatorschicht 9 ein Material mit niedrigerer und für die zweite Isolatorschicht 13 ein Material mit höherer Dielektrizitätskonstante vorteilhaft sein, wodurch die bereits durch die verschiedenen Schichtdicken vorgegebenen Unterschiede in den Kapazitätsbelägen verstärkt werden. KapazitätsElemente mit hohem Kapazitätsbelag sind beispielsweise für KapazitätsElemente hoher Güte in HF-Kreisen besonders geeignet, während die Kapazitäts-Elemente mit niedrigerem Kapazitätsbelag durch die dickere Isolator-Doppelschicht vorteilhaft zur DC-Trennung dienen können.

Die Bauelementstrukturen nach Abb. j können in an sich gebräuchlicher Weise mittels eines Dielektrikums 15 (z.B. BCB) planarisiert und nach Öffnung von Kontaktlöchern 16 über eine weitere strukturierte Metallisierung 17 kontaktiert (Abb. k) werden.

Die im Schritt b von Fig. 1 aufgebrachte Metallschicht 5 dient insbesondere als leitende Startschicht für die galvanische Abscheidung der Verstärkungsmetallisierung 7. Bei Aufdampfen der Metallisierung 7 kann die Schicht 5 als Leiterebene daher auch entfallen.

Bei der in Fig. 2 skizzierten Vorgehensweise wird wiederum das Substrat 1 durch ein Dielektrikum 2 passiviert (Fig. 2, a). Auf das passivierte Substrat werden nacheinander ganzflächig eine erste Widerstandsschicht 3, eine zweite Widerstandsschicht 4, eine Leiterschicht 25, eine Kontaktmetallisierung 7 und eine Photolackschicht 26 aufgebracht (Fig. 2, b). Durch Strukturierung der Photolackschicht 26 mit abgedeckten Elektrodenbereichen 261 als Ätzmaske für die Schicht 7 werden in der Schicht 7 die Strukturen 71, 72,73, 74 erzeugt (Fig. 2, c), wobei die Leiterschicht 25 als Ätzstoppschicht wirkt. In den freigelegten Bereichen 262 wird anschließend die Schicht 25 selektiv zur Schicht 4 entfernt (Fig. 2, d). Die weiteren Schritte des Herstellungsprozesses entsprechen den zu Fig. 1, Abb. e bis k dargelegten Schritten.

Wenn die Schicht 7 selektiv zur zweiten Widerstandsschicht 4 ätzbar ist, kann auf die Schicht 5 auch verzichtet werden. Die Schicht 5 kann aber evtl. auch als Haftvermittler, Diffusionsbarriere etc. dienen.

Die vorstehend und die in den Ansprüchen angegebenen sowie die den Abbildungen entnehmbaren Merkmale sind sowohl einzeln als auch in verschiedenen Kombinationen vorteilhaft realisierbar.

## Patentansprüche

1. Verfahren zur Herstellung wenigstens eines Dünnschicht-Widerstands-Elements und wenigstens eines Kapazitäts-Elements auf einem Substrat, wobei
1a) auf dem gegebenenfalls passivierten Substrat (1,2) nacheinander eine erste hochohmige Widerstandsschicht (3), auf dieser eine zweite niederohmige Widerstandsschicht (4) und auf dieser eine Kontaktschicht (5, 7), die für Elektroden und Anschlüsse vorgesehen ist, abgeschieden werden,
1b) in der Kontaktschicht (5, 7) Strukturen (71, 72, 73, 74) für Anschlüsse und untere Elektroden von Kapazitäts-Elementen erzeugt werden,
1c) Bauelemente durch Freiätzen von Trennbereichen separiert werden, 1d)
auf der nach 1b) strukturierten Kontaktschicht (5, 7) und der Widerstandsschicht (4) ganzflächig eine erste Isolatorschicht (9) aufgebracht wird,
1e) in Form von Öffnungen in der ersten Isolatorschicht (9) über nach 1b) erzeugten unteren Elektroden Strukturen (11a) für erste Kapazitäten erzeugt werden,
1f) auf den in 1e) erzeugten Strukturen (11a) eine zweite Isolatorschicht (13) abgeschieden wild und
1g) in einer über der zweiten Isolatorschicht (13) liegenden Metallisierungsschicht obere Elektroden (141, 142) für Kapazitäts-Elemente erzeugt werden.
wobei im Schritt 1e) zusammen mit der Herstellung der Strukturen (11a) in der ersten Isolatorschicht für erste Kapazitätselemente mittels einer gemeinsamen Maske Strukturen (11b) für erste Widerstände erzeugt werden.

2. Verfahren nach Anspruch 1, **dadurch gekennzeichnet, dass** die zweite Isolatorschicht ganzflächig abgeschieden wird.

3. Verfahren nach einem der Ansprüche 1 bis 2, **dadurch gekennzeichnet, dass** für die zweite Isolatorschicht (13) ein für die darunterliegende Widerstandsschicht (3) korrosionsschützendes Material gewählt wird.

4. Verfahren nach einem der Ansprüche 1 bis 3, **dadurch gekennzeichnet, daß** die Strukturen (71, 72, 73, 74) der Kontaktschicht (5, 7) dadurch erzeugt werden, dass auf einer Metallschicht als ganzflächig abgeschiedener Leiterebene (5) eine Photolackschicht aufgetragen wird, in welcher Elektrodenbereiche freigelegt werden, und dass in den freigelegten Elektrodenbereichen die Metallschicht durch eine dickere Kontaktmetallisierung (7) verstärkt wird und nicht verstärkte Leiterflächen der Leiterebene (5) entfernt werden.

5. Verfahren nach einem der Ansprüche 1 bis 4, **dadurch gekennzeichnet, dass** die Kontaktschicht (5, 7) ganzflächig abgeschieden und danach zur Erzeugung der Strukturen (71, 72, 73, 74) strukturiert entfernt wird.

6. Verfahren nach einem der Ansprüche 1 bis 5, **dadurch gekennzeichnet, dass** die Strukturen (71, 72, 73, 74) durch strukturiertes Abscheiden einer Kontaktmetallisierung (7) auf der zweiten Widerstandsschicht (4) erzeugt werden.

7. Verfahren nach einem der Ansprüche 1 bis 6, **dadurch gekennzeichnet, dass** hochohmige Widerstände durch Entfernen der niederohmigen Widerstandsschicht (4) in separierten Widerstands-Bauelementen mit den Strukturen (11b) nach Schritt 1e erzeugt werden.

8. Verfahren nach einem der Ansprüche 1 bis 7, **dadurch gekennzeichnet, dass** über in 1e) freigelegten und mit der zweiten Isolatorschicht (13) bedeckten unteren Elektroden (71) obere Elektroden (141) für erste Kapazitäts-Elemente höherer spezifischer Kapazität erzeugt werden.

9. Verfahren nach einem der Ansprüche 1 bis 8, **dadurch gekennzeichnet, dass** über in 1e) nicht freigelegten und mit der ersten und der zweiten Isolatorschicht bedeckten unteren Kapazitäts-Elektroden (72) obere Kapazitäts-Elektroden (142) für zweite Kapazitäts-Elemente geringerer spezifischer Kapazität erzeugt werden.

10. Verfahren nach einem der Ansprüche 1 bis 9, **dadurch gekennzeichnet, dass** für die zweite Isolatorschicht (13) ein Material mit höherer Dielektrizitätskonstante gewählt wird als für die erste Isolatorschicht (9).

## Claims

1. Method for producing at least one thin-film resistor element and at least one capacitor element on a substrate, wherein
1a) there are successively deposited on the substrate (1, 2), which is passivated, if appropriate, a first high-resistance resistor layer (3), on the latter a second low-resistance resistor layer (4) and on the latter a contact layer (5, 7), which is provided for electrodes and terminals,
1b) structures (71, 72, 73, 74) for terminals and bottom electrodes of capacitor elements are produced in the contact layer (5, 7),
1c) components are separated by isolating regions being etched free,
1d) a first insulator layer (9) is applied over the whole area on the contact layer (5, 7) patterned according to 1b) and the resistor layer (4),
1e) structures (11a) for first capacitors are produced in the form of openings in the first insulator layer (9) above bottom electrodes produced according to 1b),
1f) a second insulator layer (13) is deposited on the structures (11a) produced in 1e), and
1g) top electrodes (141, 142) for capacitor elements are produced in a metallization layer lying above the second insulator layer (13),
wherein, in step 1e), structures (11b) for first resistors are produced together with the production of the structures (11a) in the first insulator layer for first capacitor elements by means of a common mask.

2. Method according to Claim 1, **characterized in that** the second insulator layer is deposited over the whole area.

3. Method according to either of Claims 1 and 2, **characterized in that** a material which effects corrosion protection for the underlying resistor layer (3) is chosen for the second insulator layer (13).

4. Method according to one of Claims 1 to 3, **characterized in that** the structures (71, 72, 73, 74) of the contact layer (5, 7) are produced by the fact that a photoresist layer is applied on a metal layer as conductor plane (5) deposited over the whole area, electrode regions being uncovered in said photoresist layer, and that in the uncovered electrode regions the metal layer is reinforced by a thicker contact metallization (7) and non-reinforced conductor areas of the conductor plane (5) are removed.

5. Method according to one of Claims 1 to 4, **characterized in that** the contact layer (5, 7) is deposited over the whole area and then removed in patterned fashion in order to produce the structures (71, 72, 73, 74).

6. Method according to one of Claims 1 to 5, **characterized in that** the structures (71, 72, 73, 74) are produced by patterned deposition of a contact metallization (7) on the second resistor layer (4).

7. Method according to one of Claims 1 to 6, **characterized in that** high-resistance resistors are produced by removal of the low-resistance resistor layer (4) in separated resistor components with the structures (11b) according to step 1e.

8. Method according to one of Claims 1 to 7, **characterized in that** top electrodes (141) for first capacitor elements of higher specific capacitance are produced above bottom electrodes (71) which are uncovered in 1e) and covered with the second insulator layer (13).

9. Method according to one of Claims 1 to 8, **characterized in that** top capacitor electrodes (142) for second capacitor elements of lower specific capacitance are produced above bottom capacitor electrodes (72) which are not uncovered in 1e) and are covered with the first and second insulator layers.

10. Method according to one of Claims 1 to 9, **characterized in that** a material with a higher dielectric constant is chosen for the second insulator layer (13) than for the first insulator layer (9).

## Revendications

1. Procédé pour fabriquer au moins un élément résistif à couche mince et au moins un élément capacitif sur un substrat, procédé selon lequel
1a) sur le substrat (1, 2) éventuellement rendu passif sont déposées l'une après l'autre une première couche résistive à haute résistance (3), sur celle-ci une deuxième couche résistive à faible résistance (4) et sur celle-ci une couche de contact (5, 7) qui est prévue pour des électrodes et des bornes,
1b) des structures (71, 72, 73, 74) pour des bornes et des électrodes inférieures d'éléments capacitifs sont générées dans la couche de contact (5, 7),
1c) des éléments de construction sont séparés par gravure de dégagement de zones de séparation,
1d) une première couche isolante (9) est appliquée sur toute la surface de la couche de contact (5, 7) structurée selon 1b) et de la couche résistive (4), 1e) des structures (11a) pour des premières capacités sont générées sous la forme d'ouvertures dans la première couche isolante (9) inférieures électrodes générées selon 1b),
1f) une deuxième couche isolante (13) est déposée sur les structures (11a) générées en 1e) et
1g) des électrodes supérieures (141, 142) pour des éléments capacitifs sont générées dans une deuxième couche de métallisation qui se trouve au-dessus de la deuxième couche isolante (13),
des structures (11b) pour des premières résistances étant générées au moyen d'un masque commun à l'étape 1e), conjointement avec la fabrication des structures (11a) dans la première couche isolante pour les premiers éléments capacitifs.

2. Procédé selon la revendication 1, **caractérisé en ce que** la deuxième couche isolante est déposée sur toute la surface.

3. Procédé selon l'une des revendications 1 à 2, **caractérisé en ce que** pour la deuxième couche isolante (13) est choisi un matériau qui protège contre la corrosion la couche résistive (3) qui se trouve au-dessous.

4. Procédé selon l'une des revendications 1 à 3, **caractérisé en ce que** les structures (71, 72, 73, 74) de la couche de contact (5, 7) sont générées **en ce qu'**une couche de vernis photosensible, dans laquelle sont libérées des zones d'électrode, est appliquée sur une couche métallique sous la forme d'un plan conducteur (5) déposé sur toute la surface, et **en ce que** dans les zones d'électrode libérées, la couche métallique est renforcée par une métallisation de contact (7) plus épaisse et les surfaces conductrices non renforcées du plan conducteur (5) sont retirées.

5. Procédé selon l'une des revendications 1 à 4, **caractérisé en ce que** la couche de contact (5, 7) est déposée sur toute la surface et ensuite retirée de façon structurée en vue de la génération des structures (71, 72, 73, 74).

6. Procédé selon l'une des revendications 1 à 5, **caractérisé en ce que** les structures (71, 72, 73, 74) sont générées par une déposition structurée d'une métallisation de contact (7) sur la deuxième couche résistive (4).

7. Procédé selon l'une des revendications 1 à 6, **caractérisé en ce que** des résistances à haute valeur sont générées en retirant la couche résistive à faible résistance (4) dans des éléments de construction résistifs séparés avec les structures (11b) selon l'étape 1e).

8. Procédé selon l'une des revendications 1 à 7, **caractérisé en ce que** des électrodes supérieures (141) pour des premiers éléments capacitifs ayant une capacité spécifique plus élevée sont générées sur les électrodes inférieures (71) libérées dans 1e) et recouvertes par la deuxième couche isolante (13).

9. Procédé selon l'une des revendications 1 à 8, **caractérisé en ce que** des électrodes de capacité supérieures (142) sont générées pour des deuxièmes éléments capacitifs ayant une capacité spécifique plus faible sur les électrodes de capacité inférieures (72) non libérées dans 1e) et recouvertes par la première et la deuxième couche isolante.

10. Procédé selon l'une des revendications 1 à 9, **caractérisé en ce que** le matériau choisi pour la deuxième couche isolante (13) présente une constante diélectrique plus élevée que celui pour la première couche isolante (9).
